# EUROPEAN PATENT SPECIFICATION

(11) **EP 3 862 760 B1**
(45) Date of publication and mention of the grant of the patent: **21.12.2022**
(21) Application number: 20155759.2
(22) Date of filing: 06.02.2020
(51) Int. Cl.: G01R 15/04, G01R 15/14

(54) **INSULATED COMPONENT OF A VOLTAGE SENSOR**
ISOLIERTE KOMPONENTE EINES SPANNUNGSSENSORS
COMPOSANT ISOLÉ D'UN CAPTEUR DE TENSION

(43) Date of publication of application: 11.08.2021
(73) Proprietor: 3M Innovative Properties Company, Saint Paul, MN 55133-3427 (US)
(72) Inventor: Gravermann, Mark, 41812 Erkelenz (DE); Stollwerck, Dr. Gunther, 47802 Krefeld (DE); Stalder, Mr. Michael, 47589 Uedem (DE); Weichold, Mr. Jens, 41812 Erkelenz (DE); Schubert, Mr. Bernd, 50823 Köln (DE)
(74) Representative: Müller, Bruno

(56) References cited:
- WO-A1-2004/081589
- WO-A1-2018/229675
- US-A1- 2016 005 511
- US-A1- 2016 341 768

## Description

The present disclosure relates to voltage sensors for high-voltage and medium-voltage power distribution networks, to components of such sensors, to sensored cables for such power distribution networks, and to power distribution networks comprising such sensors.

Power distribution networks transmitting electrical power in large geographic areas, such as national grids, are becoming more complex to operate because nowadays consumers can generate energy on their premises and feed it into these networks in a decentralized manner, at unpredictable times and in unpredictable amounts. Network operators place voltage sensing devices in electrical installations at key locations of their network, such as at cable ends in switchgears or transformers to collect information about the current state of their power network.

A rather common type of voltage sensing devices for this purpose comprises a voltage divider, i.e. a chain of impedance elements (resistors, capacitors or inductors), electrically serially connected between an element on the elevated voltage to be sensed and electrical ground. Such a voltage divider is described, for example, in the European patent application published as EP 3 223 024 A1.

WO 2018/229675 A1 discloses an impedance assembly for use in a voltage divider for sensing an AC voltage, comprising at least two dividing capacitors, electrically connected in series between the high-voltage contact and the low-voltage contact.

Voltage dividers generally have a high-voltage portion and a low-voltage portion. The high-voltage portion is electrically arranged between the connection to the elevated voltage and a signal contact at which a divided voltage can be picked up that varies proportionally with the elevated voltage, whereas the low-voltage portion is electrically arranged between the signal contact and the connection of the voltage divider to ground.

The high-voltage portion of voltage dividers in high-voltage or medium-voltage networks must generally be electrically insulated to reduce the risk of electrical discharges to elements on ground. It has been found advantageous to combine the insulation of a cable end, such as in a switchgear or transformer, e.g. the insulation of a power cable termination, and the insulation of the high-voltage portion of the voltage divider. This combined insulation can save insulation material and space.

In some traditional insulating bodies for this purpose, e.g. as described in the European patent application EP 3 223 024 A1, an elastically expandable sleeve is used that initially has an inner diameter which is smaller than the outer diameter of the cable and that can be manually pushed over the cable end for a tight fit. However, urging the sleeve with a component of the voltage sensor in it over a cable end implies the risk of damaging the sensor. Alternatively, an elastically shrinkable sleeve is used that initially has an inner diameter which is greater than the outer diameter of the cable, held in this expanded state by a removable core, and that can be shrunk down over the cable end for a tight fit by removing the core. However, such removable cores are costly to manufacture and difficult to insert into the sleeve. Hence both approaches have their disadvantages, even beyond the fact that they require a manual step to affix the sleeve over the cable end.

The present disclosure describes alternative solutions that attempt to avoid these disadvantages. It provides in a first aspect an insulated component of a voltage sensor, wherein the voltage sensor comprises a voltage divider for sensing an elevated voltage of a power conductor in a MV/HV power distribution network of a national grid, and wherein the insulated component comprises
a) a rigid carrier tube forming a passageway for receiving a section of the power conductor and comprising an outer tube surface;
b) an insulating sleeve arranged on and around the outer tube surface and having an outer sleeve surface;
c) a primary impedance element for being in ohmic connection with the power conductor on elevated voltage and operable in a high-voltage portion of the voltage divider, wherein the primary impedance element is insulated by the sleeve and arranged between the outer tube surface and the outer sleeve surface.

The carrier tube is rigid and its passageway allows the insulated component to be pushed easily over an end of a suitably sized cable. By choosing an appropriate inner diameter of the passageway, such that the passageway is slightly larger than the diameter of the cable, an air gap that may exist between the outer surface of the cable and the inner surface of the passageway may be large enough to reduce the risk of partial discharges.

The rigid carrier tube with its fixed inner diameter can thus very easily be pushed over cables of a smaller diameter, with no need for manual urging or removal of a core. This is expected to save time during installation of the voltage sensor on a cable end or on other power conductors.

Also, the rigid carrier tube can provide a rugged support for the primary impedance element which is part of the high-voltage portion of the voltage divider, or which forms the entire high-voltage portion of the voltage divider. In certain embodiments the rigid carrier tube can support multiple impedance elements forming the high-voltage portion, or it can even support both the high-voltage portion and the low-voltage portion of the voltage divider. The presence of the rigid carrier tube may thereby facilitate easier assembly of the voltage divider and render it more rugged.

The present disclosure relates to voltage sensing devices for use in medium-voltage or high-voltage power distribution networks in which electrical power is distributed via HV/MV cables, transformers, switchgears, substations etc. with currents of hundreds of amperes and voltages of tens of kilovolts. The term "medium voltage" or "MV" as used herein refers to AC or DC voltages in the range of 1 kV to 72 kV, whereas the term "high voltage" or "HV" refers to AC or DC voltages of more than 72 kV. Medium voltage and high voltage are collectively referred to herein as "elevated voltage".

In a national grid or in other power distribution networks, the electrical power is distributed via power conductors. A power conductor may, for example, be a busbar, such as in a transformer or in a switchgear, or a power cable, such as an insulated HV/MV cable or an overhead power line. A power conductor may be, for example, a conductive element in a bushing or in a separable connector through which the power is flowing which is to be distributed.

The carrier tube is an element of tubular shape which carries the insulating sleeve and the primary impedance element. By virtue of its shape, the carrier tube forms a passageway through which the power conductor may be routed. The passageway thereby can receive a section of the power conductor in it. Generally, the carrier tube may be axially symmetric about a central axis extending in a length direction of the carrier tube. In this case also the passageway is axially symmetric and has a circular cross section. However, in certain embodiments the carrier tube may not be axially symmetric but have, for example, an oval or elliptic or an irregular cross section. The carrier tube may form a straight tube or a curved tube. In any case, the carrier tube comprises an outer surface, also referred to as "outer tube surface" herein. Where the carrier tube is axially symmetric, the outer tube surface is the radially outermost major surface of the tube, such as the outer surface of a cylinder, relative to the center of the passageway. The carrier tube also comprises an inner surface, which is the major surface oriented towards the passageway and delimiting the passageway. The thickness of the carrier tube is defined by the distance between the inner tube surface and the outer tube surface. The thickness is typically chosen to be in the range from a fraction of a millimeter to a few millimeters, e.g. from 0.1 mm to 10.0 mm, but may also be smaller or larger. Typically, the thickness of the carrier tube is the same over its entire length, although this is not necessarily so.

As used herein, a rigid carrier tube is a carrier tube which has a fixed cross section that does not change under moderate mechanical forces. In particular, it is neither radially expandable nor radially shrinkable. Its cross section is fixed and not supposed to change during normal installation of the insulated component on a power conductor. Also, a rigid carrier tube is not designed to be bendable, e.g. from a straight, e.g. cylindrical, shape into a skew shape or vice versa. The term "rigid" has its normal technical meaning and is to be understood as the opposite of the terms "flexible", "bendable", "radially expandable" and "radially shrinkable" and their synonyms.

The passageway formed by the carrier tube is an open space which extends through the entire carrier tube. The passageway may have a circular cross section. Alternatively, it may have another cross section, such as elliptical, oval, or irregular. The passageway may be delimited by the inner surface of the carrier tube, i.e. by the major surface oriented towards the passageway.

The size and cross section of the passageway is advantageously chosen such that the power conductor, e.g. a power cable, can be easily pushed through, and accommodated in, the passageway. Where a cable end is already provided with stress control elements, e.g. a stress control tube, the size and cross section of the passageway is advantageously chosen such that the power cable with the stress control elements can be easily pushed through the passageway and accommodated in the passageway.

The size and cross section of the passageway is advantageously chosen such that a gap of suitable width remains between the outer surface of the power conductor and the inner surface of the carrier tube. The gap may be filled with air or another non-conductive gas or gas mixture. A too small width of the gap may increase the risk of electrical discharges through air between the cable and the carrier tube, since the electrical field gradient is strong in this area.

In order to keep the power conductor close to the center of the passageway, centering elements may be arranged, e.g. at the beginning and at the end of the passageway, that fix the radial position of the power conductor relative to the passageway and the inner surface of the carrier tube.

The insulating sleeve surrounds the carrier tube and electrically insulates the primary impedance element which is part of the high-voltage portion of the voltage divider. Its main function is to insulate elements on elevated voltage, namely the power conductor and the primary impedance element, against electrical ground. The sleeve is therefore electrically insulating and advantageously has a sufficient thickness of an insulating material arranged around the power conductor and the primary impedance element to provide effective insulation under all operating conditions.

The insulating sleeve may be made of, or comprise, electrically insulating silicone rubber material or one or more other types of insulating polymeric material, such as EPDM (ethylene propylene diene monomer), or other types of synthetic rubber materials.

The sleeve is arranged on the carrier tube. In other words, it is in surface contact with at least portions of the outer tube surface. The sleeve may be molded around the carrier tube and the primary impedance element, so that it is in surface contact with at least portions of the carrier tube and the primary impedance element. A molded sleeve generally may help in avoiding air-filled voids which may give rise to partial discharges, as the molding material in its liquid state tends to fill all available spaces.

The sleeve is arranged around the carrier tube. It thereby surrounds the entire carrier tube over the full circumference of the carrier tube and along at least a portion of the full length of the carrier tube. Advantageously the insulating sleeve surrounds the entire carrier tube over the full circumference of the carrier tube and along the full length of the carrier tube. The apertures of the passageway, however, should not be obstructed by the sleeve, so that the power conductor can be easily pushed into the passageway.

The sleeve comprises an outer sleeve surface. This is the radially outermost major surface of the sleeve, the surface normal of which is oriented away from the carrier tube. The outer sleeve surface may be the outer surface of the insulated component of the voltage divider according to the present disclosure.

The insulating sleeve may be a tubular sleeve, i.e. It has a generally tubular shape. The insulating sleeve may be oriented such that its length direction is parallel to the length direction of the carrier tube.

The insulated component of the voltage divider as disclosed herein may comprise a high-voltage contact for ohmic connection of the primary impedance element to the power conductor on elevated voltage. The high-voltage contact of the insulated component is in ohmic connection with the primary impedance element. It may be operable to electrically connect the voltage divider to the power conductor on elevated voltage. The high-voltage contact may be, for example, a soldering contact on a printed circuit board (PCB) or an end of a wire or a contact in a connector or a metal contact in a plug body.

For an ohmic connection to the power conductor, a wire may electrically connect the primary impedance element to the power conductor on elevated voltage. In many cases an exposed portion of the power conductor is accessible outside the insulating sleeve. The wire may lead from an interior of the sleeve, such as from the high-voltage contact where one exists, to an outside of the sleeve.

Hence, in certain embodiments, the insulated component further comprises a high-voltage wire, electrically connected to the primary impedance element for ohmic connection of the primary impedance element to the power conductor and leading to an outside of the insulating sleeve.

The insulated component of the voltage divider as disclosed herein may further comprise a grounding contact for ohmic connection of the voltage divider to ground.

The voltage divider for sensing the elevated voltage may comprise a high-voltage portion comprising the primary impedance element and optionally further impedance elements, electrically serially connected with each other and electrically connected to the high-voltage contact. The voltage divider may further comprise a low-voltage portion comprising one or more further impedance elements, serially connected between the high-voltage portion and ground. In addition, additional impedance elements, connected electrically parallel between the high-voltage portion and ground may be present in the low-voltage portion. Also, additional impedance elements, connected electrically parallel to the primary impedance element may be present in the high-voltage portion.

The insulated component according to the present disclosure may comprise the entire high-voltage portion, including the primary impedance element and, optionally, one or more further impedance elements, of the high-voltage portion of the voltage divider. The further impedance elements may be arranged between the outer tube surface and the outer sleeve surface.

The low-voltage portion of the voltage divider may be arranged away from the insulated component and outside the insulating sleeve. However, in advantageous embodiments the low-voltage portion of the voltage divider may be comprised in the insulated component. The low-voltage portion of the voltage divider may, for example, be arranged in or on the insulated component. The low-voltage portion may be arranged inside the insulating sleeve, e.g. it may be embedded in the insulating sleeve. In certain advantageous embodiments the insulated component according to the present disclosure comprises the low-voltage portion of the voltage divider. One or a plurality or all of the further impedance elements of the low-voltage portion may be arranged between the outer tube surface and the outer sleeve surface.

The primary impedance element is an element that provides electrical impedance. The primary impedance element may be, for example, a capacitor, a resistor or an inductor. Generally, in the context of the present disclosure, the term "impedance element" refers to a capacitor, a resistor, or an inductor. An impedance element may be a discrete impedance element, i.e. a discrete capacitor, a discrete resistor, or a discrete inductor. As used herein, a discrete impedance element is an individual impedance element that exists independently from other electrical elements, from a printed circuit board ("PCB") or from conductive traces on a PCB. In particular, a discrete impedance element is not formed by conductive traces on an outer surface of a PCB, or in a PCB. A discrete impedance element may be, in particular, a surface mount discrete impedance element, i.e. one that is designed to be mounted on an outer surface of a PCB.

The primary impedance element is operable in a high-voltage portion of a voltage divider for sensing the elevated voltage of the power conductor. The voltage divider may be an element of a voltage sensor for sensing, i.e. measuring with an adequate precision, the elevated voltage relative to electrical ground. The voltage divider may be electrically connected between the power conductor on elevated voltage and electrical ground, for sensing the elevated voltage.

The primary impedance element may be an impedance element of the voltage divider which is electrically connected to the elevated voltage directly, i.e. without other impedance elements being electrically arranged between the primary impedance element and the elevated voltage. The primary impedance element may be the impedance element of the voltage divider which "sees" the undivided elevated voltage on its input side. A further impedance element may be an impedance element which is electrically connected to the elevated voltage indirectly, i.e. with one or more other impedance elements being electrically arranged between the further impedance element and the elevated voltage.

The voltage divider may further comprise a signal contact, electrically arranged between the high-voltage portion and the low-voltage portion of the voltage divider, for providing a signal voltage indicative of the elevated voltage. Where the high-voltage contact is electrically connected to the primary impedance element and to the power conductor on elevated voltage, and where the grounding contact is connected to ground, the voltage at the signal contact changes proportionally to the elevated voltage. The proportionality factor depends on the dividing ratio of the voltage divider, i.e. on the overall impedance of the high-voltage portion versus the overall impedance of the entire voltage divider. By suitably choosing the overall impedances of the high-voltage portion and of the low-voltage portion, the dividing ratio can be adjusted for the voltage divider to yield a suitable signal voltage at the signal contact. Preferably, the signal voltage is in the range of from about 0.1 Volt to about 100 Volt, more preferably, the signal voltage is in the range of from about 1 Volt to about 10 Volt. Multiplication of the signal voltage in Volt with the proportionality factor yields the elevated voltage in Volt.

The expression "ohmic connection" as used herein refers to a galvanic connection, i.e. a conductive electrical connection between two elements, as opposed to a capacitive coupling. An ohmic connection may be a connection having a certain electrical resistance, e.g. below 5 Ohm or below 1 Ohm.

The primary impedance element is suitable and adapted for being in ohmic connection with the power conductor on elevated voltage. In certain embodiments the primary impedance element is the voltage-dividing element of the voltage divider that is directly electrically connected to the power conductor, i.e. connected such that the full elevated voltage is available at one side of the primary impedance element.

The voltage divider comprises a high-voltage portion and a low-voltage portion. The high-voltage portion comprises one or more impedance elements, one of which is the primary impedance element. While the primary impedance element is comprised in the insulated component as described herein, one or several or all of the further impedance elements of the high-voltage portion may be comprised in the insulated component as described herein. One or several or all of the further impedance elements of the high-voltage portion may be arranged between the outer tube surface and the outer sleeve surface and insulated by the sleeve. Alternatively, one or several or all of the further impedance elements of the high-voltage portion may be not comprised in, e.g. separate from, the insulated component as described herein.

Similarly, the low-voltage portion of the voltage divider comprises one or more impedance elements. One or several or all of the impedance elements of the low-voltage portion may be comprised in the insulated component as described herein. One or several or all of the impedance elements of the low-voltage portion may be arranged between the outer tube surface and the outer sleeve surface and insulated by the sleeve. Alternatively, one or several or all of the impedance elements of the low-voltage portion may be not comprised in, e.g. separate from, the insulated component as described herein.

The primary impedance element is operable in a high-voltage portion of the voltage divider. The primary impedance element can thus be used as an impedance element to divide the elevated voltage. It may be the only impedance element of the high-voltage portion or it may be one impedance element out of a plurality of impedance elements of the high-voltage portion. The primary impedance element thereby contributes to providing, at the signal contact, a signal voltage that varies proportionally with the elevated voltage.

In an insulated component of a voltage divider according to the present disclosure the primary impedance element is arranged between the outer tube surface and the outer sleeve surface. This implies that the primary impedance element is located "below" (i.e. radially inward of) the outer sleeve surface. A portion of the insulating sleeve may thus cover the primary impedance element. The primary impedance element is therefore embedded between (i.e. radially between) a portion of the insulating sleeve and the carrier tube. This may be achieved, for example, by first arranging the primary impedance element on the outer tube surface and then molding the insulating sleeve material over the outer tube surface and around the primary impedance element and let the material harden.

In other embodiments, the insulating sleeve is molded around the carrier tube such that after molding around the carrier tube the insulating sleeve forms a cavity into which the primary impedance element can be inserted. The primary impedance element is thereby arranged inside the sleeve and hence arranged between the outer tube surface and the outer sleeve surface.

In use the primary impedance element is on elevated voltage, e.g. on a voltage of a few tens of kilovolt. The insulating sleeve insulates the primary impedance element with respect to elements on electrical ground in its vicinity.

The power conductor may be not insulated itself, such as, for example, a busbar or a stripped portion of a power cable or an overhead power line. The insulating sleeve also insulates the power conductor on elevated voltage with respect to elements on electrical ground or on a low voltage in the vicinity of the sleeve. The material(s) and the size and shape of the insulating sleeve are thus advantageously chosen such that the sleeve provides a sufficient electrical insulation of the power conductor and the primary impedance element contained in the sleeve with respect to elements on electrical ground in the vicinity of the insulating sleeve.

The insulated component, or the voltage divider, may comprise more impedance elements than the primary impedance element that are part of the voltage divider. These further impedance elements are advantageously connected in series with each other. In certain embodiments it may be advantageous that the number of these further serially-connected impedance elements is large, so that the high voltage is divided down in more, but smaller steps. These further impedance elements may be arranged outside the insulating sleeve, but more advantageously they may be insulated by the sleeve and may thus be arranged between the outer tube surface and the outer surface of the insulating sleeve.

Hence in certain embodiments the insulated component comprises a plurality of further impedance elements, electrically connected in series with each other and with the primary impedance element, wherein the primary impedance element and the plurality of further impedance elements are comprised in the voltage divider, and wherein the plurality of further impedance elements is insulated by the sleeve and arranged between the outer tube surface and the outer sleeve surface.

The outer surface of the carrier tube may be provided with conductive traces or paths via a process called laser direct structuring. In a laser direct structuring process, a plastic part, such as the carrier tube, is manufactured from a specially doted plastic. In a second step surface areas of the plastic part are "activated" by a laser. In a third step a conductive metal such as copper can be deposited on these activated plastic surface areas to form conductive traces on the surface of the plastic part, such as on the tube outer surface. The primary impedance element (and further impedance elements, if present) can be electrically connected to other elements via such conductive traces. Hence no dedicated printed circuit board to support the conductive traces is required.

Therefore, in certain embodiments the insulated component according to the present disclosure further comprises conductive traces on the outer tube surface, electrically connected with the primary impedance element.

Where the carrier tube has conductive traces on its outer surface, the carrier tube may also serve as a support for the primary impedance element and optionally for further impedance elements of the voltage divider. The use of a printed circuit board for supporting the conductive traces and the impedance elements may thereby be made obsolete. Therefore, in certain embodiments, the primary impedance element is arranged on the outer tube surface. In other embodiments, the primary impedance element and the further impedance elements are arranged on the outer tube surface.

In order to provide additional mechanical stability and/or additional electrical insulation to the primary impedance element and any further impedance elements, they can be encapsulated in a rigid encapsulation body. Such an encapsulation body can be formed from, for example, a resin material that, while still liquid, is molded around the impedance element(s) and is then let dry to become rigid.

The material of the encapsulation body may fill spaces in the vicinity of impedance elements that would otherwise be filled with air. Where such a material is electrically non-conductive the encapsulation body may reduce the risk of electrical discharges. In particular, where the material of the encapsulation body has a permittivity higher than the permittivity of air, it may help reduce this risk even more.

Therefore, in certain embodiments of the insulated component according to the present disclosure, the primary impedance element is encapsulated in a rigid, non-conductive encapsulation body.

For enhanced insulation the encapsulation body with the impedance element(s) encapsulated in it may be embedded in the insulating sleeve, i.e. it may be accommodated between the outer surface of the carrier tube and the outer surface of the insulating sleeve. Hence in certain embodiments the encapsulation body is arranged between the outer tube surface and the outer sleeve surface.

The primary impedance element - and further impedance elements, if present - may be supported on a printed circuit board (PCB), as mentioned above. The PCB may be a rigid PCB or a flexible (i.e. bendable) PCB. Flexible PCBs are often made of materials like, for example, PTFE (polytetrafluoroethylene), or polyimide.

Where impedance elements are mounted on a flexible PCB, the assembly of PCB and impedance elements can be easily brought into various desired shapes. This may be important in scenarios where the shape or thickness of the insulating sleeve is not known until late in a production process. Also, mounting on flexible PCBs allows to wrap the PCB supporting the primary impedance element (and potentially supporting further impedance elements) around other elements to support the PCB and fix the position of the PCB within the insulating sleeve in which it is embedded and insulated.

In certain embodiments of an insulated component of a voltage sensor according to the present disclosure the primary impedance element is arranged on a flexible printed circuit board, and the flexible printed circuit board is insulated by the sleeve and arranged between the outer tube surface and the outer sleeve surface.

A flexible PCB may be arranged wrapped around the carrier tube. The carrier tube being rigid, the carrier tube may stabilize the PCB, support it and protect it against overly sharp bending. It may be found advantageous if the flexible PCB is smaller than the outer tube surface, so that the entire PCB can be supported by the carrier tube, and no portion of the PCB remains unsupported.

Therefore, in certain embodiments, the flexible printed circuit board is arranged wrapped around at least a portion of the carrier tube.

The carrier tube may have different shapes which may depend on the type of power conductor that is to be received in its passageway, or which may depend on the space available for the insulated component. The carrier tube may have, for example, a circular, an elliptical or an oval cross section. Its cross section may be square or rectangular, or irregular. In certain embodiments the carrier tube has a circular, an elliptical or an oval cross section.

It may be generally advisable to have no voids between the primary impedance element, in particular its outer surface, and the interior surface of the sleeve adjacent to the surface of the primary impedance element, as such voids may increase the risk of electrical discharges between the primary impedance element and portions of the insulating sleeve, due to a strong electrical field gradient in that area. A good surface contact and a reduced number of voids may be achieved, for example, by molding the sleeve material around the carrier tube and the primary impedance element. Hence in certain embodiments a surface portion of the sleeve is in mechanical contact with a surface portion of the primary impedance element.

Under other circumstances it may be desirable to have no direct mechanical contact of the primary impedance element with a surface portion of the sleeve. The primary impedance element may, for example, be encapsulated in an encapsulation body that itself is in surface contact with the primary impedance element. An insulating sleeve may also form an internal cavity in which the primary impedance element is suspended without contacting a surface of the sleeve.

In certain embodiments the primary impedance element is a discrete capacitor, a discrete resistor, a discrete inductor, a ceramic resistor, a surface-mount capacitor, a surface-mount resistor, or a surface-mount inductor. Discrete capacitors, discrete resistors, discrete inductors, ceramic resistors, surface-mount capacitors, surface-mount resistors, or surface-mount inductors are all suitable components to build high-precision voltage dividers. They are generally more easily replaceable than corresponding embedded components. Such components are commercially available at moderate cost and at high precision ratings.

The present disclosure also provides a sensored cable comprising a) a high-voltage or medium-voltage power cable having a power conductor, and b) an insulated component of a voltage sensor as described herein, wherein a section of the power conductor is received in the passageway, and wherein the primary impedance element is in ohmic connection with the power conductor. The sensored cable with the insulated component mounted on it may thereby be easily provided with a voltage sensor. Where the insulated component comprises the entire voltage divider, i.e. the high-voltage portion and the low-voltage portion of the voltage divider, only a voltmeter or the like may need to be connected to sense the signal voltage and to measure the elevated voltage of the power conductor.

Where such a sensored cable comprises an insulation layer around the power conductor, the inner diameter of the passageway may be chosen such as to provide a gap between an inner surface of the carrier tube and an outer surface of the insulation layer. A suitably sized gap, i.e. a radial gap, may help reduce the risk of electrical discharges between the power conductor on elevated voltage and the carrier tube, in the strong electrical field around the power conductor. For an elevated AC voltage of 80 kV, for example, a gap size of about 40mm is deemed suitable to reduce the risk of electrical discharges. For an elevated AC voltage of 24 kV, for example, a gap size of about 15-20 mm is deemed suitable. Therefore, in certain embodiments, in which the power cable comprises an insulation layer around the power conductor, a diameter of the passageway is chosen such as to provide a gap between an inner surface of the carrier tube and an outer surface of the insulation layer. In certain embodiments, the size of the gap, i.e. its radial size, is between about 1mm and about 50mm, in certain embodiments the gap size is about 5mm, about 10mm, or about 20mm. In certain other embodiments the gap size is about 25mm, about 30mm or about 40mm or about 50mm. The gap may be filled with air or another non-conductive gas or gas mixture.

The present disclosure further provides a power distribution network of a national grid comprising a power conductor for conducting power at an elevated voltage, a voltage sensor for sensing the elevated voltage comprising a voltage divider, wherein the voltage sensor comprises an insulated component as described herein.

Certain embodiments of an insulated component of a voltage divider according to the present disclosure will now be described in more detail with reference to the following Figures:
- Fig. 1: Perspective view of a first insulated component of a voltage divider according to the present disclosure, installed on a power cable;
- Fig. 2: Further perspective view of the first insulated component of Figure 1;
- Fig. 3: Perspective view of a rigid carrier tube of a second insulated component of a voltage divider according to the present disclosure, with a PCB wrapped around it;
- Fig. 4: Perspective view of a rigid carrier tube of a third insulated component of a voltage divider according to the present disclosure, with a high-voltage resistor as primary impedance element;
- Fig. 5: Perspective view of a rigid carrier tube of a fourth insulated component of a voltage divider according to the present disclosure, with impedance elements mounted directly on the carrier tube; and
- Fig. 6: Electrical circuit diagram of a voltage divider usable with devices according to the present disclosure.

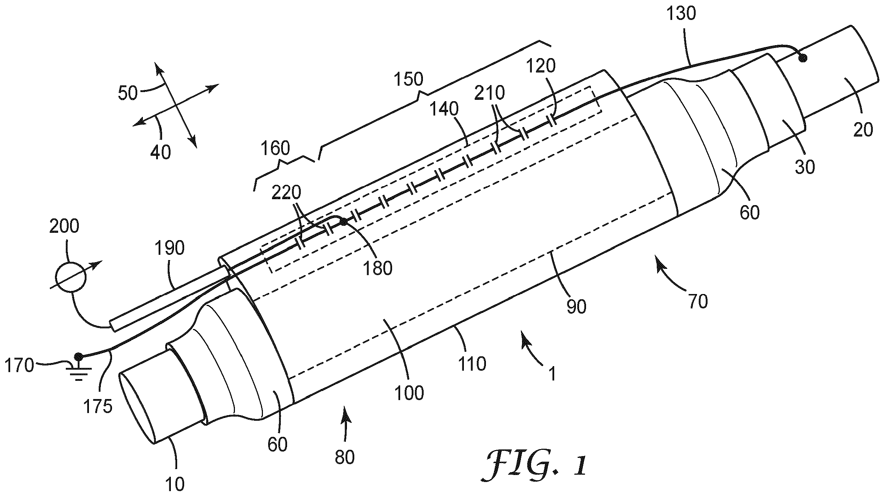

The perspective view of **Figure** 1 illustrates a first insulated component 1 of a voltage divider according to the present disclosure, installed on an end of a power cable 10 of a medium-voltage power distribution network of a national grid. The end of the cable 10 is stripped, so that the central power conductor 20 and the main insulation layer 30 are visible. The length direction 40 of the cable 10 defines axial directions 40 and radial directions 50, orthogonal to the axial directions 40.

The insulated component 1 is installed on the cable 10. Its position on the cable 10 in axial directions 40 is fixed by two cold-shrink sleeves 60, shrunk down over the cable 10 adjacent to opposed end portions 70, 80 of the insulated component 1, namely a first sleeve 60 adjacent to the high-voltage end portion 70 - which is closer to the exposed power conductor 20 on elevated voltage - and a second sleeve 60 adjacent to the low-voltage end portion 80, further from the exposed power conductor 20.

The insulated component 1 comprises a rigid carrier tube 90, indicated in dashed lines in Figure 1, which forms a passageway in which a section of the power conductor 20 is received. The carrier tube 90 is made from a polymeric material, e.g. from polyamide, and has a cylindrical shape, with its inner diameter being slightly larger than the outer diameter of the main insulation layer 30.

The insulated component 1 further comprises an insulating sleeve 100 of a non-conductive synthetic rubber material which is arranged around the carrier tube 90. The outer surface 110 of the sleeve 100 forms the outer surface of the insulated component 1.

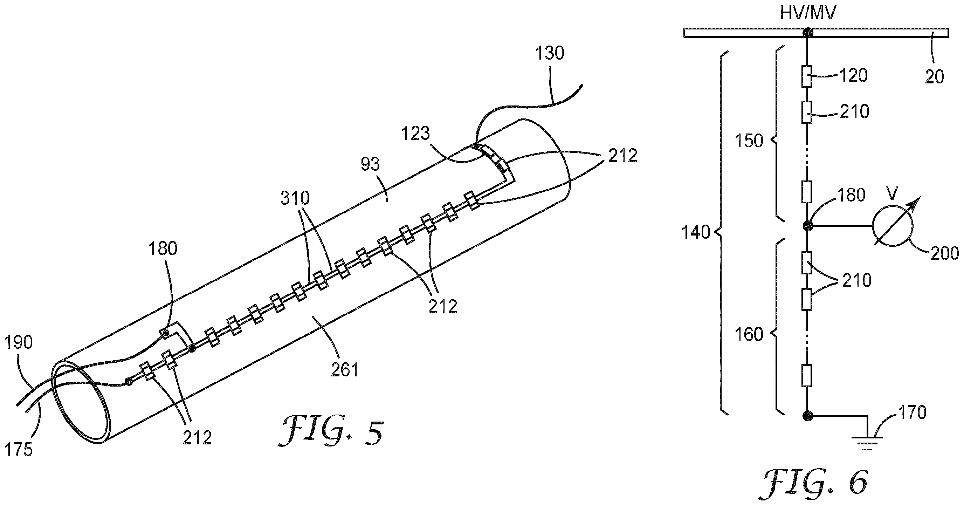

The insulated component 1 further comprises a primary impedance element 120, namely a discrete capacitor 120, in ohmic connection with the power conductor 20 via a high-voltage wire 130. The primary impedance element 120 is operated in a capacitive voltage divider 140, indicated by a rectangle in dashed line, which is electrically connected between the power conductor 20 on elevated voltage and electrical ground 170, for sensing the elevated voltage. An electrical circuit diagram of a voltage divider 140 usable with an insulated component 1 is shown in Figure 6.

The voltage divider 140 in turn comprises a high-voltage portion 150, a low-voltage portion 160 and a signal contact 180, electrically arranged between the high-voltage portion 150 and the low-voltage portion 160, at which a divided voltage can be picked up which varies proportionally with the elevated voltage of the power conductor 20. The divided voltage is thus a signal voltage, which is made available outside the insulating sleeve 100 by a signal wire 190. By measuring the signal voltage vis-à-vis electrical ground 170 via a voltmeter 200 and multiplying it with the dividing ratio of the voltage divider 140 yields the elevated voltage of the power conductor 20. A grounding wire 175 connects the voltage divider 140 to electrical ground 170.

The high-voltage portion 150 of the voltage divider 140 comprises the primary impedance element 120 and seven further impedance elements 210, indicated by respective circuit diagram symbols. The low-voltage portion 160 comprises two impedance elements 220, electrically arranged between the signal contact 180 and ground 170.

The primary impedance element 120 and the further impedance elements 210, 220 are discrete capacitors, arranged on a printed circuit board (PCB, not shown) in a cavity formed inside the insulating sleeve 100, between the outer surface of the carrier tube 90 and the outer surface 110 of the sleeve 100. The primary impedance element 120 and the further impedance elements 210, 220 are thereby embedded in the sleeve 100 and electrically insulated by the sleeve 100.

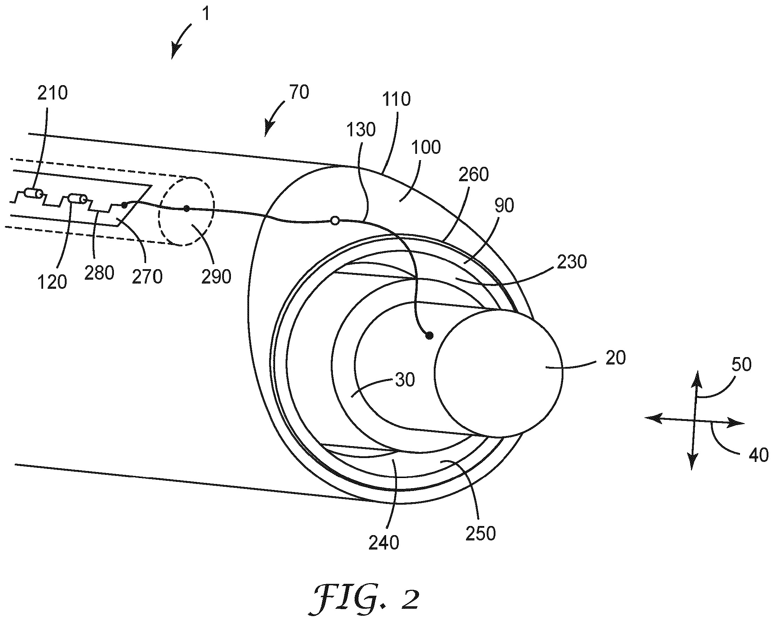

**Figure 2** illustrates in more detail, in a different perspective view, partially cut-away, elements of the first insulated component 1 as installed on the end of the cable 10. The cold-shrink sleeve 60 at the high-voltage end portion 70 is not shown for greater clarity. The power conductor 20 and the main insulation layer 30 form the stripped end of the cable 10. The passageway 230 formed by the rigid carrier tube 90 receives the end section of the cable 10. An air gap 240 of about 20mm size remains between the outer surface of the cable insulation 30 and the inner surface 250 of the carrier tube 90.

The insulating sleeve 100 is arranged on the outer surface 260 of the carrier tube 90 ("outer tube surface" 260), and it extends around the full perimeter of the outer tube surface 260, without forming gaps or voids.

Embedded in the insulating material of the insulating sleeve 100 is a voltage divider 140, of which the primary impedance element 120 and one of the further impedance elements 210 are shown, both mounted on a PCB 270 and electrically connected in series by conductive traces 280 on the PCB 270. The PCB 270 and all impedance elements 120, 210 of the voltage divider 140 mounted on the PCB 270 are encapsulated in a solid, rigid encapsulation body 290 of an electrically insulating material. The encapsulation body 290 is made from a hardened resin which was molded around the PCB 270 and the impedance elements 120, 210 while the resin was still liquid, and the resin was then let harden to form the encapsulation body 290. The encapsulation body 290 does not extend up to the end of the insulating sleeve 100, but is completely surrounded by the sleeve 100, in order to improve its insulation and to reduce the risk of electrical discharges from the encapsulation body 290 to elements on ground or on low voltage.

The primary impedance element 120 is in ohmic connection with the power conductor 20 via the high-voltage wire 130 which leads from the primary impedance element 120 through the encapsulation body 290 and through the insulating sleeve 100 to the exposed portion of the power conductor 20. Via this high-voltage wire 130 the voltage divider 140 is electrically connected to the power conductor 20 on elevated voltage.

Figure 2 shows that the cross section of the insulated component 1 is not axially symmetric but rather oval, due to the presence of the impedance elements 120, 210 and the PCB 270, which require a certain amount of insulation material around them. In alternative embodiments the cross section may be axially symmetric, however.

The primary impedance element 120 of an insulated component 1 of a voltage divider 140 according to the present disclosure may be supported on a flexible printed circuit board (PCB). Flexible PCBs are well-known. The term "flexible" refers to the ability of the PCB to be flexed or bent, as opposed to non-flexible, rigid PCBs. Where the primary impedance element 120 is suitably arranged on a flexible PCB, the PCB can be wrapped around the carrier tube 90, to save space and to make assembly of the insulated component 1 easier.

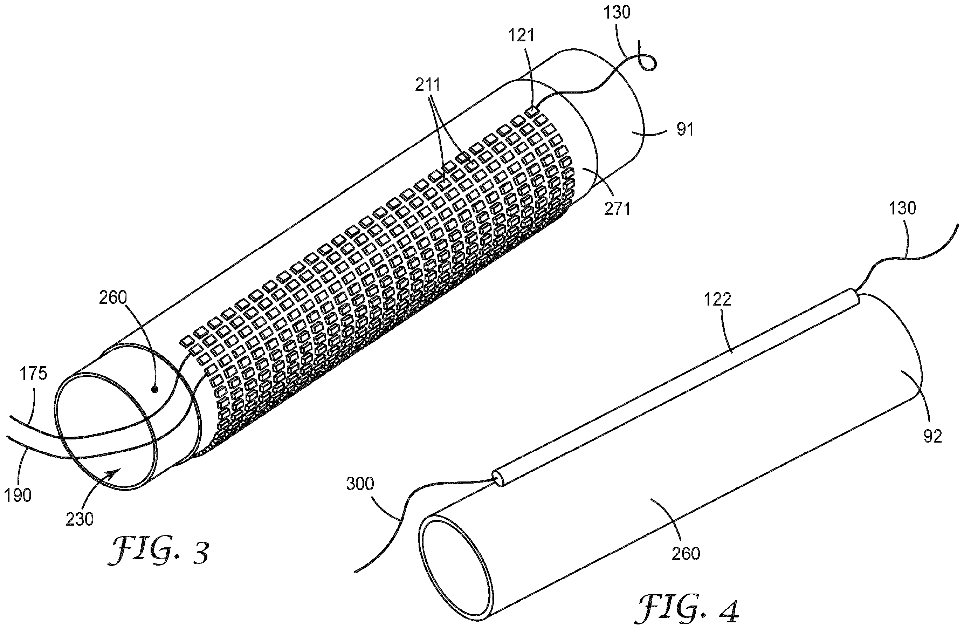

This is illustrated in **Figure 3****,** which shows, in a perspective view, the rigid carrier tube 91 of a second insulated component of a voltage divider according to the present disclosure. The second insulated component is generally similar to the first insulated component 1 shown in Figures 1 and 2, and the second carrier tube 91 is similar to the carrier tube 90 of the first insulated component 1 of Figures 1 and 2. In its passageway 230 the carrier tube 91 can receive a section of a power conductor 20 in the same manner as shown for the first insulated component 1, and an insulating sleeve similar to the insulating sleeve 100 of Figures 1 and 2 can be arranged on and around the outer tube surface 260 of the carrier tube 91 shown in Figure 3.

The primary impedance element 121 is supported, along with a large number of further impedance elements 211, on a flexible PCB 271. The flexible PCB 271 is arranged wrapped around the carrier tube 91. The primary impedance element 121 and the further impedance elements 211 form a voltage divider 140 for sensing an elevated voltage of a power conductor 20 in a MV/HV power distribution network, as shown in Figure 6.

The further impedance elements 211 are comprised in the high-voltage portion 150 and in the low-voltage portion 160 of the voltage divider 140, respectively. The voltage divider is electrically similar to the voltage divider 140 of Figure 1, except that the number of further impedance elements 211 is much higher. The further impedance elements 211 are electrically connected in series and in parallel to form a low-voltage portion 160 and a high-voltage portion 150. Connections between the primary impedance element 121 and the further impedance elements 211 and between the further impedance elements 211 are not shown for clarity.

The primary impedance element 121 can be put in ohmic connection with the power conductor by a high-voltage wire 130, to which the primary impedance element 121 is electrically connected. A signal wire 190 leads the divided voltage to outside an insulating sleeve (not shown) arranged on and around the outer tube surface 260. A grounding wire 175 connects the voltage divider on the PCB 271 to electrical ground.

The PCB 271 and the impedance elements 121, 211 of the voltage divider may be overmolded with a liquid material which, once hardened, forms the insulating sleeve on and around the carrier tube 91, similar to the insulating sleeve 100 in Figures 1 and 2. The impedance elements 121, 211 and the PCB 271 would thereby be arranged between the outer tube surface 260 and the outer sleeve surface 110 and embedded between the carrier tube 91 and the outer sleeve surface 110.

The PCB 271 may be arranged directly on the outer tube surface 260, as is shown in Figure 3, or it may be held at a radial distance from the outer tube surface 260, e.g. by a spacer.

It may be noted that the primary impedance element 121 and the further impedance elements 211 and the PCB 271 are not encapsulated in a rigid encapsulation body. This is because the rigid carrier tube 91 mechanically stabilizes the PCB 271 and the impedance elements 121, 211 on it, by virtue of the PCB 271 being wrapped directly around the outer tube surface 260. A further stabilization by a rigid encapsulation body is therefore obsolete.

In an insulated component of a voltage divider according to the present disclosure the primary impedance element may be a single resistor. This is illustrated in **Figure 4** in a perspective view showing a rigid carrier tube 92 and a primary impedance element 122 of a third insulated component of a voltage divider.

The primary impedance element 122 is a single high-voltage ceramic resistor 122 of a cylindrical, elongated shape. It is arranged directly on the outer surface 260 of the carrier tube 92, with its length direction oriented parallel to the length direction of the carrier tube 92.

The primary impedance element 122 is comprised in a high-voltage portion 150 of a voltage divider 140 as shown in Figure 6. The further impedance elements 210 (not shown in Figure 4) of the voltage divider 140, i.e. of the high-voltage portion 150 or of the low-voltage portion 160 of the voltage divider 140, are arranged remote from the carrier tube 92 and are connected to the primary impedance element 122 by a connecting wire 300.

The primary impedance element 122 may be overmolded with a liquid material which, once hardened, forms an insulating sleeve, similar to the insulating sleeve 100 in Figures 1 and 2, on and around the carrier tube 92 and the primary impedance element 122. The primary impedance element 122 would thereby be arranged between the outer tube surface 260 and the outer sleeve surface 110 and embedded between the carrier tube 92 and the outer sleeve surface 110.

The primary impedance element 122 may be arranged directly on the outer tube surface 260, as is shown in Figure 4, or it may be held at a radial distance from the outer tube surface 260, e.g. by a spacer.

Again, the primary impedance element 122 is not encapsulated in a rigid encapsulation body. This is because the rigid carrier tube 92 mechanically stabilizes the primary impedance element 122 on it, as the primary impedance element 122 is arranged directly on the outer tube surface 260. A further stabilization by a rigid encapsulation body is therefore obsolete.

The resistor 122 is connected to a high-voltage wire 130 through which the resistor 122 and the voltage divider 140 can be brought into ohmic electrical connection with a power conductor 20.

**Figure 5** is a perspective view of a yet further rigid carrier tube 93 and a further primary impedance element 123 of a further, fourth insulated component of a voltage divider. In this embodiment, the primary impedance element 123 is a surface-mounted resistor 123, mounted directly on the outer surface 261 of the rigid carrier tube 93. Further impedance elements 212, which are surface-mounted devices or SMDs, are also mounted directly on the outer surface 261 of the rigid carrier tube 93. No additional PCB is required for mounting.

Conductive traces 310 connect the impedance elements 123, 212 with each other such as to form a voltage divider 140. The conductive traces 310 consist of copper and are arranged directly on the tube outer surface 261 by a technique referred to generally as laser direct structuring. In a laser direct structuring process, a plastic part (the carrier tube 93) is manufactured, e.g. by injection molding, using a specially doted plastic. In a second step surface areas of the plastic part are "activated" by a laser. In a third step a conductive metal such as copper can be deposited on this activated plastic surface areas to form conductive traces 310 on the surface of the plastic part, i.e. on the tube outer surface 261.

Surface-mountable impedance elements 123, 212, e.g. surface-mount capacitors, surface-mount resistors and/or surface-mount inductors, can be soldered to the ends of the conductive traces 310. The impedance elements 123, 212 and the conductive traces 310 on the tube outer surface 261 can be directly overmolded, e.g. with a non-conductive silicone rubber material, to form an insulating sleeve 100 for insulating the primary impedance element 123 and the further impedance elements 212. The primary impedance element 123 and the further impedance elements 212 would thereby be arranged between the outer tube surface 261 and the outer sleeve surface 110 and embedded between the carrier tube 93 and the outer sleeve surface 110, as shown in Figures 1 and 2 for the insulating sleeve 100 of the first insulated component 1.

The laser direct structuring process can also form a signal contact 180 at which a divided voltage can be picked up that varies proportionally with the elevated voltage of the power conductor. A signal wire 190 conducts the signal voltage to outside the insulated sleeve 100, and a grounding wire 175 connects the voltage divider 140 to electrical ground. On the high-voltage side of the voltage divider 140, a high-voltage wire 130 is electrically connected to the primary impedance element 123, operable to bring the primary impedance element 123 into ohmic connection with a power conductor 20.

**Figure 6** is a circuit diagram illustrating the voltage divider 140 of the insulated components 1 for sensing an elevated voltage of a power conductor 20 in a MV/HV power distribution network as described herein. The voltage divider 140 is connected between the power conductor 20 on elevated voltage and electrical ground 170. A divided voltage, the "signal voltage", varying proportionally with the elevated voltage, can be picked up at a signal contact 180 and sensed by a voltmeter 200 or a so-called remote terminal unit (RTU). The voltage divider 140 comprises a high-voltage portion 150, electrically arranged between the elevated voltage and the signal contact 180, and a low-voltage portion 160, electrically arranged between the signal contact 180 and ground 170. The high-voltage portion 150 comprises at least the primary impedance element 120, but may comprise further impedance elements 210, electrically connected in series with each other between the elevated voltage of the power conductor 20 and the signal contact 180. The low-voltage portion 160 comprises one or more further impedance elements 210, electrically connected in series with each other between the signal contact 180 and electrical ground 170.

## Claims

1. Insulated component (1) of a voltage sensor, wherein the voltage sensor comprises a voltage divider (140) for sensing an elevated voltage of a power conductor (20) in a MV/HV power distribution network of a national grid, the insulated component is **characterised by**
a) a rigid carrier tube (90, 91, 92, 93) forming a passageway (230) for receiving a section of the power conductor (20) and comprising an outer tube surface (260);
b) an insulating sleeve (100) arranged on and around the outer tube surface (260) and having an outer sleeve surface (110);
c) a primary impedance element (120, 121, 122, 123) for being in ohmic connection with the power conductor (20) on elevated voltage and operable in a high-voltage portion (150) of the voltage divider (140),
wherein the primary impedance element is insulated by the sleeve and arranged between the outer tube surface (260) and the outer sleeve surface (110).

2. Insulated component (1) according to claim 1, comprising a plurality of further impedance elements (210, 211, 212), electrically connected in series with each other and with the primary impedance element (120, 121, 122, 123),
wherein the primary impedance element and the plurality of further impedance elements are comprised in the voltage divider (140), and
wherein the plurality of further impedance elements is insulated by the sleeve and arranged between the outer tube surface (260) and the outer sleeve surface (110).

3. Insulated component (1) according to any one of the preceding claims, further comprising conductive traces (310) on the outer tube surface (93), electrically connected with the primary impedance element (120, 121, 122, 123).

4. Insulated component (1) according to any one of the preceding claims, wherein the primary impedance element (120, 121, 122, 123) is arranged on the outer tube surface (90, 91, 92, 93).

5. Insulated component (1) according to claim 1, wherein the primary impedance element (120, 121, 122, 123) is encapsulated in a rigid, non-conductive encapsulation body (290).

6. Insulated component (1) according to claim 5, wherein the encapsulation body (290) is arranged between the outer tube surface (260) and the outer sleeve surface (110).

7. Insulated component (1) according to any one of claims 1-2, wherein the primary impedance element (120, 121, 122, 123) is arranged on a flexible printed circuit board (271), and wherein the flexible printed circuit board is insulated by the sleeve (100) and arranged between the outer tube surface (260) and the outer sleeve surface (110).

8. Insulated component (1) according to claim 7, wherein the flexible printed circuit board (271) is arranged wrapped around at least a portion of the carrier tube (90, 91, 92, 93).

9. Insulated component (1) according to any one of the preceding claims, further comprising a high-voltage wire (130), electrically connected to the primary impedance element (120, 121, 122, 123) for ohmic connection of the primary impedance element to the power conductor (20) and leading to an outside of the insulating sleeve (100).

10. Insulated component (1) according to any one of the preceding claims, wherein the carrier tube (90, 91, 92, 93) has a circular, an elliptical or an oval cross section.

11. Insulated component (1) according to any one of the preceding claims, wherein a surface portion of the sleeve (100) is in mechanical contact with a surface portion of the primary impedance element (120, 121, 122, 123).

12. Insulated component (1) according to any one of the preceding claims, wherein the primary impedance element is a discrete capacitor (120), a discrete resistor (122), a discrete inductor, a ceramic resistor (122), a surface-mount capacitor (123), a surface-mount resistor, or a surface-mount inductor.

13. Sensored cable comprising
a) a high-voltage or medium-voltage power cable (10) having a power conductor (20), and
b) an insulated component (1) according to any one of claims 1 to 12,
wherein a section of the power conductor (20) is received in the passageway (230), and wherein the primary impedance element is in ohmic connection with the power conductor (20).

14. Sensored cable according to claim 13, wherein the power cable (10) comprises an insulation layer (30) around the power conductor (20), and wherein a diameter of the passageway (230) is chosen such as to provide a gap (240) between an inner surface (250) of the carrier tube (90, 91, 92, 93) and an outer surface of the insulation layer.

15. Power distribution network of a national grid comprising a power conductor (20) for conducting power at an elevated voltage, a voltage sensor for sensing the elevated voltage comprising a voltage divider (140), wherein the voltage sensor comprises an insulated component (1) according to any one of claims 1 to 12.

## Patentansprüche

1. Isolierte Komponente (1) eines Spannungssensors, wobei der Spannungssensor einen Spannungsteiler (140) zum Erfassen einer erhöhten Spannung eines Stromleiters (20) in einem Mittelspannungs-/Hochspannungs-Stromverteilungsnetz eines nationalen Netzes umfasst, wobei die isolierte Komponente **gekennzeichnet ist durch**
a) ein starres Trägerrohr (90, 91,92, 93), das einen Durchgang (230) zum Aufnehmen eines Abschnitts des Stromleiters (20) bildet und eine äußere Rohroberfläche (260) aufweist;
b) eine Isolierhülse (100), die auf und um die äußere Rohroberfläche (260) angeordnet ist und eine äußere Hülsenoberfläche (110) aufweist;
c) ein primäres Impedanzelement (120, 121, 122, 123) zum ohmschen Verbinden mit dem Stromleiter (20) auf erhöhter Spannung und betreibbar in einem Hochspannungsabschnitt (150) des Spannungsteilers (140),
wobei das primäre Impedanzelement **durch** die Hülse isoliert und zwischen der äußeren Rohroberfläche (260) und der äußeren Hülsenoberfläche (110) angeordnet ist.

2. Isolierte Komponente (1) nach Anspruch 1, aufweisend eine Mehrzahl von weiteren Impedanzelementen (210, 211, 212), die elektrisch miteinander und mit dem primären Impedanzelement (120, 121, 122, 123) in Reihe geschaltet sind,
wobei das primäre Impedanzelement und die Mehrzahl von weiteren Impedanzelementen in dem Spannungsteiler (140) enthalten sind, und
wobei die Mehrzahl von weiteren Impedanzelementen durch die Hülse isoliert und zwischen der äußeren Rohroberfläche (260) und der äußeren Hülsenoberfläche (110) angeordnet sind.

3. Isolierte Komponente (1) nach einem der vorstehenden Ansprüche, ferner aufweisend Leiterbahnen (310) auf der äußeren Rohroberfläche (93), die elektrisch mit dem primären Impedanzelement (120, 121, 122, 123) verbunden sind.

4. Isolierte Komponente (1) nach einem der vorstehenden Ansprüche, wobei das primäre Impedanzelement (120, 121, 122, 123) auf der äußeren Rohroberfläche (90, 91, 92, 93) angeordnet ist.

5. Isolierte Komponente (1) nach Anspruch 1, wobei das primäre Impedanzelement (120, 121, 122, 123) in einem starren, nicht leitfähigen Kapselungskörper (290) eingekapselt ist.

6. Isolierte Komponente (1) nach Anspruch 5, wobei der Kapselungskörper (290) zwischen der äußeren Rohroberfläche (260) und der äußeren Hülsenoberfläche (110) angeordnet ist.

7. Isolierte Komponente (1) nach einem der Ansprüche 1 bis 2, wobei das primäre Impedanzelement (120, 121, 122, 123) auf einer flexiblen Leiterplatte (271) angeordnet ist und wobei die flexible Leiterplatte durch die Hülse (100) isoliert und zwischen der äußeren Rohroberfläche (260) und der äußeren Hülsenoberfläche (110) angeordnet ist.

8. Isolierte Komponente (1) nach Anspruch 7, wobei die flexible Leiterplatte (271) um mindestens einen Abschnitt des Trägerrohrs (90, 91, 92, 93) gewickelt angeordnet ist.

9. Isolierte Komponente (1) nach einem der vorstehenden Ansprüche, ferner aufweisend einen Hochspannungsdraht (130), der elektrisch mit dem primären Impedanzelement (120, 121, 122, 123) zur ohmschen Verbindung des primären Impedanzelements mit dem Stromleiter (20) verbunden ist und zu einer Außenseite der Isolierhülse (100) führt.

10. Isolierte Komponente (1) nach einem der vorstehenden Ansprüche, wobei das Trägerrohr (90, 91, 92, 93) einen kreisförmigen, einen elliptischen oder einen ovalen Querschnitt aufweist.

11. Isolierte Komponente (1) nach einem der vorstehenden Ansprüche, wobei ein Oberflächenabschnitt der Hülse (100) mit einem Oberflächenabschnitt des primären Impedanzelements (120, 121, 122, 123) in mechanischem Kontakt steht.

12. Isolierte Komponente (1) nach einem der vorstehenden Ansprüche, wobei das primäre Impedanzelement ein diskreter Kondensator (120), ein diskreter Widerstand (122), eine diskrete Spule, ein keramischer Widerstand (122), ein oberflächenmontierter Kondensator (123), ein oberflächenmontierter Widerstand oder eine oberflächenmontierte Spule ist.

13. Mit Sensoren versehenes Kabel, aufweisend
a) ein Hochspannungs- oder Mittelspannungskabel (10), das einen Stromleiter (20) aufweist, und
b) eine isolierte Komponente (1) nach einem der Ansprüche 1 bis 12, wobei ein Abschnitt des Stromleiters (20) in dem Durchgang (230) aufgenommen ist und wobei das primäre Impedanzelement in ohmscher Verbindung mit dem Stromleiter (20) steht.

14. Mit Sensoren versehenes Kabel nach Anspruch 13, wobei das Stromkabel (10) eine Isolierschicht (30) um den Stromleiter (20) herum umfasst und wobei ein Durchmesser des Durchgangs (230) derart ausgewählt ist, dass ein Spalt (240) zwischen einer Innenoberfläche (250) des Trägerrohrs (90, 91, 92, 93) und einer Außenoberfläche der Isolierschicht bereitgestellt wird.

15. Stromverteilungsnetz eines nationalen Netzes, aufweisend einen Stromleiter (20) zum Leiten von Strom bei einer erhöhten Spannung, einen Spannungssensor zum Erfassen der erhöhten Spannung, der einen Spannungsteiler (140) aufweist, wobei der Spannungssensor eine isolierte Komponente (1) nach einem der Ansprüche 1 bis 12 aufweist.

## Revendications

1. Composant isolé (1) d'un capteur de tension, dans lequel le capteur de tension comprend un diviseur de tension (140) pour la détection d'une tension élevée d'un conducteur d'alimentation (20) dans un réseau de distribution d'alimentation MT/HT d'une infrastructure nationale, le composant isolé est **caractérisé par**
a) un tube de support rigide (90, 91, 92, 93) formant une voie de passage (230) pour la réception d'une section du conducteur d'alimentation (20) et comprenant une surface de tube externe (260) ;
b) un manchon isolant (100) agencé sur et autour de la surface de tube externe (260) et ayant une surface de manchon externe (110) ;
c) un élément d'impédance primaire (120, 121, 122, 123) pour une connexion ohmique avec le conducteur d'alimentation (20) sur une tension élevée et opérationnel dans une partie haute tension (150) du diviseur de tension (140),
dans lequel l'élément d'impédance primaire est isolé par le manchon et agencé entre la surface de tube externe (260) et la surface de manchon externe (110).

2. Composant isolé (1) selon la revendication 1, comprenant une pluralité d'éléments d'impédance supplémentaires (210, 211, 212), connectés électriquement en série les uns avec les autres et avec l'élément d'impédance primaire (120, 121, 122, 123),
dans lequel l'élément d'impédance primaire et la pluralité d'éléments d'impédance supplémentaires sont compris dans le diviseur de tension (140), et
dans lequel la pluralité d'éléments d'impédance supplémentaires est isolée par le manchon et agencée entre la surface de tube externe (260) et la surface de manchon externe (110).

3. Composant isolé (1) selon l'une quelconque des revendications précédentes, comprenant en outre des traces conductrices (310) sur la surface de tube externe (93), connectées électriquement à l'élément d'impédance primaire (120, 121, 122, 123).

4. Composant isolé (1) selon l'une quelconque des revendications précédentes, dans lequel l'élément d'impédance primaire (120, 121, 122, 123) est agencé sur la surface de tube externe (90, 91, 92, 93).

5. Composant isolé (1) selon la revendication 1, dans lequel l'élément d'impédance primaire (120, 121, 122, 123) est encapsulé dans un corps d'encapsulation rigide non conducteur (290).

6. Composant isolé (1) selon la revendication 5, dans lequel le corps d'encapsulation (290) est agencé entre la surface de tube externe (260) et la surface de manchon externe (110).

7. Composant isolé (1) selon l'une quelconque des revendications 1 à 2, dans lequel l'élément d'impédance primaire (120, 121, 122, 123) est agencé sur une carte de circuit imprimé flexible (271), et dans lequel la carte de circuit imprimé flexible est isolée par le manchon (100) et agencée entre la surface de tube externe (260) et la surface de manchon externe (110).

8. Composant isolé (1) selon la revendication 7, dans lequel la carte de circuit imprimé flexible (271) est agencée enroulée autour d'au moins une partie du tube de support (90, 91, 92, 93).

9. Composant isolé (1) selon l'une quelconque des revendications précédentes, comprenant en outre un fil haute tension (130), connecté électriquement à l'élément d'impédance primaire (120, 121, 122, 123) pour une connexion ohmique de l'élément d'impédance primaire au conducteur d'alimentation (20) et conduisant vers l'extérieur du manchon isolant (100).

10. Composant isolé (1) selon l'une quelconque des revendications précédentes, dans lequel le tube de support (90, 91, 92, 93) a une section transversale circulaire, elliptique ou ovale.

11. Composant isolé (1) selon l'une quelconque des revendications précédentes, dans lequel une partie de surface du manchon (100) est en contact mécanique avec une partie de surface de l'élément d'impédance primaire (120, 121, 122, 123).

12. Composant isolé (1) selon l'une quelconque des revendications précédentes, dans lequel l'élément d'impédance primaire est un condensateur distinct (120), une résistance distincte (122), un inducteur distinct, une résistance céramique (122), un condensateur monté en surface (123), une résistance montée en surface, ou un inducteur monté en surface.

13. Câble à capteurs, comprenant
a) un câble d'alimentation haute tension ou moyenne tension (10) ayant un conducteur d'alimentation (20), et
b) un composant isolé (1) selon l'une quelconque des
revendications 1 à 12, dans lequel une section du conducteur d'alimentation (20) est reçue dans la voie de passage (230), et dans lequel l'élément d'impédance primaire est en connexion ohmique avec le conducteur d'alimentation (20).

14. Câble à capteurs selon la revendication 13, dans lequel le câble d'alimentation (10) comprend une couche d'isolation (30) autour du conducteur d'alimentation (20), et dans lequel un diamètre de la voie de passage (230) est choisi de manière à fournir un espace (240) entre une surface interne (250) du tube de support (90, 91, 92, 93) et une surface externe de la couche d'isolation.

15. Réseau de distribution d'énergie d'une infrastructure nationale comprenant un conducteur d'alimentation (20) pour la conduite d'une alimentation à une tension élevée, un capteur de tension pour la détection de la tension élevée comprenant un diviseur de tension (140), dans lequel le capteur de tension comprend un composant isolé (1) selon l'une quelconque des revendications 1 à 12.
